# EUROPEAN PATENT APPLICATION

(11) **EP 2 128 893 A1**
(43) Date of publication of application: **02.12.2009**
(21) Application number: 08711608.3
(22) Date of filing: 20.02.2008
(51) Int. Cl.: H01L 21/304, B24B 37/00

(54) **AQUEOUS DISPERSION FOR CHEMICAL MECHANICAL POLISHING AND METHOD OF CHEMICAL MECHANICAL POLISHING OF SEMICONDUCTOR DEVICE**

(30) Priority: 22.03.2007 JP 2007074537
(71) Applicant: JSR Corporation, Tokyo 104-8410 (JP)
(72) Inventor: ANDOU, Michiaki, Tokyo 104-8410 (JP); KONNO, Tomohisa, Tokyo 104-8410 (JP)
(74) Representative: TBK-Patent
(86) International application number: PCT/JP2008/052802
(87) International publication number: WO 2008/114563

(57) **Abstract**

A chemical mechanical polishing aqueous dispersion according to the invention includes (A) 0.1 to 4 mass% of colloidal silica having an average particle diameter of 10 to 100 nm, and (B) 0.1 to 3 mass% of at least one ammonium salt selected from ammonium phosphate, diammonium phosphate, and ammonium hydrogen sulfate, the chemical mechanical polishing aqueous dispersion having a mass ratio (A)/(B) of the component (A) to the component (B) of 1 to 3 and a pH of 4 to 5 and being able to simultaneously polish at least two films that form a polishing target surface and are selected from a polysilicon film, a silicon nitride film, and a silicon oxide film.

## Description

### TECHNICAL FIELD

The present invention relates to a chemical mechanical polishing aqueous dispersion used when producing a semiconductor device, and a chemical mechanical polishing method using the chemical mechanical polishing aqueous dispersion.

### BACKGROUND ART

Various materials (e.g., polysilicon film (polycrystalline silicon film), single-crystal silicon film, silicon oxide film, silicon nitride film, aluminum, tungsten, and copper) are normally exposed on a polishing target surface subjected to chemical mechanical polishing (hereinafter may be referred to as "CMP").

One target material is normally removed by CMP by using a chemical mechanical polishing aqueous dispersion (hereinafter may be referred to as "slurry") for the target material. However, if the polishing rate ratio of the target material to other materials is large, the target material may be polished to a large extent so that defects such as dishing or erosion may occur. Moreover, since it is necessary to select a chemical mechanical polishing aqueous dispersion corresponding to each target material for removing the target material by CMP, the productivity inevitably decreases.

In recent years, it has been desired to simultaneously polish a polysilicon film, a silicon nitride film, and a silicon oxide film along with diversification of the structure of semiconductor devices. In order to simultaneously polish these three materials, a chemical mechanical polishing aqueous dispersion that ensures an almost equal polishing rate for each film is required.

JP-A-11-176773, JP-A-2001-7061, JP-A-2001-35820, JP-2002-190458, JP-A-2004-269577, and the like disclose chemical mechanical polishing aqueous dispersions having a polishing rate ratio of a silicon nitride film to a silicon oxide film of about one, for example. However, a chemical mechanical polishing aqueous dispersion that can simultaneously polish a polysilicon film, a silicon oxide film, and a silicon nitride film at an equal polishing rate has not been proposed.

### DISCLOSURE OF THE INVENTION

An objective of the invention is to provide a chemical mechanical polishing aqueous dispersion that can polish a polysilicon film, a silicon nitride film, and a silicon oxide film at sufficient and almost equal polishing rates, and a chemical mechanical polishing method for a semiconductor device using the chemical mechanical polishing aqueous dispersion.

According to the invention, there is provided a chemical mechanical polishing aqueous dispersion comprising: (A) 0.1 to 4 mass% of colloidal silica having an average particle diameter of 10 to 100 nm; and (B) 0.1 to 3 mass% of at least one ammonium salt selected from ammonium phosphate, diammonium phosphate, and ammonium hydrogen sulfate, the chemical mechanical polishing aqueous dispersion having a mass ratio (A)/(B) of the component (A) to the component (B) of 1 to 3 and a pH of 4 to 5 and being used to simultaneously polish at least two films that form a polishing target surface and are selected from a polysilicon film, a silicon nitride film, and a silicon oxide film.

The chemical mechanical polishing aqueous dispersion according to the invention may further comprise at least one compound selected from nitric acid, sulfuric acid, carbonic acid, lactic acid, formic acid, benzoic acid, citric acid, tartaric acid, malic acid, malonic acid, fumaric acid, maleic acid, succinic acid, oxalic acid, phthalic acid, adipic acid, sebacic acid, and ammonium salts of nitric acid, sulfuric acid, carbonic acid, lactic acid, formic acid, benzoic acid, citric acid, tartaric acid, malic acid, malonic acid, fumaric acid, maleic acid, succinic acid, oxalic acid, phthalic acid, adipic acid, and sebacic acid.

In the chemical mechanical polishing aqueous dispersion according to the invention, a polishing rate ratio of the polysilicon film to the silicon oxide film (polysilicon film/silicon oxide film) and a polishing rate ratio of the silicon nitride film to the silicon oxide film (silicon nitride film/silicon oxide film) may be in a range from 0.9 to 1.1.

According to the invention, there is provided a chemical mechanical polishing method for a semiconductor device, the method comprising simultaneously polishing at least two films that form a polishing target surface and are selected from a polysilicon film, a silicon nitride film, and a silicon oxide film by using the above chemical mechanical polishing aqueous dispersion.

The chemical mechanical polishing aqueous dispersion according to the invention can polish the polysilicon film, the silicon nitride film, and the silicon oxide film at sufficient and almost equal polishing rates. Therefore, at least two films that form the polishing target surface and are selected from the polysilicon film, the silicon nitride film, and the silicon oxide film can be polished simultaneously. When chemically and mechanically polishing a device having a polysilicon film, a silicon nitride film, and a silicon oxide film by using the chemical mechanical polishing aqueous dispersion according to the invention, the polysilicon film, the silicon nitride film, and the silicon oxide film can be polished and removed successively without changing a slurry corresponding to the polishing target. Moreover, since each film can be polished at an almost equal polishing rate, the desired thickness can be achieved by controlling the polishing time.

### BRIEF DESCRIPTION OF THE DRAWINGS

FIG. 1 is a cross-sectional view schematically showing an evaluation substrate used in a first experimental example.
FIG. 2 is a cross-sectional view schematically showing an evaluation substrate used in a first experimental example.
FIG. 3 is a cross-sectional view schematically showing an evaluation substrate used in a first experimental example.
FIG. 4 is a cross-sectional view schematically showing an evaluation substrate used in a second experimental example.
FIG. 5 is a cross-sectional view schematically showing an evaluation substrate used in a second experimental example.
FIG. 6 is a cross-sectional view schematically showing an evaluation substrate used in a second experimental example.

### BEST MODE FOR CARRYING OUT THE INVENTION

Embodiments of the invention are described below.

Note that the invention is not limited to the following embodiments. The invention includes various modifications without departing from the spirit and scope of the invention.

### 1. Chemical mechanical polishing aqueous dispersion

A chemical mechanical polishing aqueous dispersion according to the invention includes (A) 0.1 to 4 mass % of colloidal silica having an average particle diameter of 10 to 100 nm, and (B) 0.1 to 3 mass% of at least one ammonium salt selected from ammonium phosphate, diammonium phosphate, and ammonium hydrogen sulfate, the chemical mechanical polishing aqueous dispersion having a mass ratio (A)/(B) of the component (A) to the component (B) of 1 to 3 and a pH of 4 to 5 and being used to simultaneously polish at least two films that form a polishing target surface and are selected from a polysilicon film, a silicon nitride film, and a silicon oxide film. The details of each component of the chemical mechanical polishing aqueous dispersion according to this embodiment are given below.

### 1.1 Colloidal silica (A)

The chemical mechanical polishing aqueous dispersion according to this embodiment includes the colloidal silica as abrasive grains. The average particle diameter of the colloidal silica is preferably 10 to 100 nm, more preferably 20 to 90 nm, and particularly preferably 30 to 80 nm. If the average particle diameter of the colloidal silica is 10 to 100 nm, the chemical mechanical polishing aqueous dispersion exhibits excellent storage stability. Therefore, the performance (e.g., polishing rate) of the chemical mechanical polishing aqueous dispersion immediately after production can be ensured. If the average particle diameter of the colloidal silica is less than 10 nm, the polishing rates of the polysilicon film, the silicon nitride film, and the silicon oxide film decrease to a large extent. If the average particle diameter of the colloidal silica is more than 100 nm, the silicon oxide film is mechanically polished by the colloidal silica so that the polishing rate of the silicon oxide film increases to a large extent (i.e., the polishing rate balance is lost).

The average particle diameter of the colloidal silica is measured by a dynamic light scattering method using a dynamic light scattering particle size analyzer ("LB550" manufactured by Horiba Ltd.), for example. The term "average particle diameter of the colloidal silica" used herein refers to the average diameter of secondary particles formed by aggregated primary particles. Since the colloidal silica normally forms secondary particles when exerting a mechanical polishing effect on the polishing target surface, the average diameter of the secondary particles are evaluated as the average particle diameter of the colloidal silica.

The colloidal silica is preferably added in an amount of 0.1 to 4 mass%, more preferably 0.2 to 4 mass%, and particularly preferably 0.3 to 3.9 mass%, based on the mass of the chemical mechanical polishing aqueous dispersion during use. If the amount of the colloidal silica is less than 0.1 mass%, a sufficient polishing rate cannot be achieved. If the amount of the colloidal silica is more than 4 mass%, the silicon oxide film is mechanically polished by the colloidal silica so that the polishing rate of the silicon oxide film increases to a large extent. Moreover, defects such as scratches may occur during polishing.

The term "sufficient polishing rate" used herein refers to a polishing rate of 20 nm/min or more.

### 1.2 Acid ammonium salt (B)

The chemical mechanical polishing aqueous dispersion according to this embodiment includes at least one ammonium salt selected from ammonium phosphate, diammonium phosphate, and ammonium hydrogen sulfate. The polishing rate of the silicon nitride film can be increased by adding such an acid ammonium salt.

It is considered that ammonium phosphate and diammonium phosphate increase the polishing rate of the silicon nitride film due to the chemical polishing effect of phosphate ions on the silicon nitride film and the chemical polishing effect of ammonium ions on the silicon nitride film.

It is considered that ammonium hydrogen sulfate increases the polishing rate of the silicon nitride film due to the chemical polishing effect of sulfuric acid ions on the silicon nitride film and the chemical polishing effect of ammonium ions on the silicon nitride film.

These acid ammonium salts may be used either individually or in combination.

The acid ammonium salt is preferably added in an amount of 0.1 to 3 mass%, more preferably 0.2 to 2.5 mass%, and particularly preferably 0.3 to 1.3 mass%, based on the mass of the chemical mechanical polishing aqueous dispersion during use. If the amount of the acid ammonium salt is less than 0.1 mass%, the polishing rate decreases to a large extent. The polishing rate of the silicon nitride film increases to only a small extent even if the acid ammonium salt is added in amount of more than 3 mass%. On the other hand, the stability of the chemical mechanical polishing aqueous dispersion decreases if the amount of the acid ammonium salt is more than 3 mass%.

In the chemical mechanical polishing aqueous dispersion according to this embodiment, the mass ratio (A)/(B) of the colloidal silica (A) to the ammonium salt (B) is 1 to 3. The mass ratio (A)/(B) is preferably 1.3 to 2.8, and particularly preferably 1.5 to 2.5. If the mass ratio (A)/(B) is within this range, the polishing rates of the polysilicon film, the silicon nitride film, and the silicon oxide film can be made almost equal. Therefore, a chemical mechanical polishing aqueous dispersion suitable for simultaneously polishing these films can be obtained. If the mass ratio (A)/(B) is less than 1, the mechanical polishing effect decreases (i.e., the balance between the mechanical polishing effect and the chemical polishing effect is lost). As a result, the polishing rates of the polysilicon film, the silicon nitride film, and the silicon oxide film cannot be made almost equal. If the mass ratio (A)/(B) is more than 3, the mechanical polishing effect increases (i.e., the polishing rate of the silicon oxide film increases). As a result, the polishing rates of the polysilicon film, the silicon nitride film, and the silicon oxide film cannot be made almost equal.

### 1.3 pH

The pH of the chemical mechanical polishing aqueous dispersion according to this embodiment is 4 to 5. If the pH of the chemical mechanical polishing aqueous dispersion is within this range, the polishing rates of the polysilicon film, the silicon nitride film, and the silicon oxide film can be made almost equal. The pH of the chemical mechanical polishing aqueous dispersion may be adjusted by adjusting the amounts of the components (A) and (B), and adding an acid or a base described later. The pH of the chemical mechanical polishing aqueous dispersion is preferably 4.2 to 4.8. If the pH of the chemical mechanical polishing aqueous dispersion is less than 4, the polishing rate of the polysilicon film cannot be increased while the polishing rates of the silicon nitride film and the silicon oxide film are increased. As a result, the object of the invention cannot be achieved. If the pH of the chemical mechanical polishing aqueous dispersion is more than 5, the polishing rates of the silicon nitride film and the silicon oxide film cannot be increased while the polishing rate of the polysilicon film is increased. As a result, the object of the invention cannot be achieved.

Specifically, since the pH of the chemical mechanical polishing aqueous dispersion is closely related to the polishing rates of the polysilicon film, the silicon nitride film, and the silicon oxide film, the pH of the chemical mechanical polishing aqueous dispersion must be controlled precisely. The chemical mechanical polishing aqueous dispersion according to this embodiment may be prepared as a buffer using a citric acid buffer, a phosphoric acid buffer, or the like.

### 1.4 Other additives

The chemical mechanical polishing aqueous dispersion according to this embodiment may include additives given below, if necessary.

### 1.4.1 Acid or acid ammonium salt

The chemical mechanical polishing aqueous dispersion according to this embodiment may include an acid or an acid ammonium salt, if necessary. Examples of the acid or the acid ammonium salt include nitric acid, sulfuric acid, carbonic acid, lactic acid, formic acid, benzoic acid, citric acid, tartaric acid, malic acid, malonic acid, fumaric acid, maleic acid, succinic acid, oxalic acid, phthalic acid, adipic acid, sebacic acid, and ammonium salts thereof. The polishing rates of the silicon nitride film and the silicon oxide film can be increased by adding such an acid or acid ammonium salt. This makes it possible to finely adjust the balance between the polishing rates of the polysilicon film, the silicon nitride film, and the silicon oxide film.

### 1.4.2 Surfactant

The chemical mechanical polishing aqueous dispersion according to this embodiment may include a surfactant, if necessary. Examples of the surfactant include a cationic surfactant, an anionic surfactant, a nonionic surfactant, and an amphoteric surfactant.

Examples of the cationic surfactant include an aliphatic amine salt, an aliphatic ammonium salt, and the like.

Examples of the anionic surfactant include a carboxylate, a sulfonate, a sulfate salt, a phosphate salt, and the like. Examples of the carboxylate include a fatty acid soap, an alkyl ether carboxylate, and the like. Examples of the sulfonate include an alkylbenzenesulfonate, an alkylnaphthalenesulfonate, an alpha-olefin sulfonate, and the like. Examples of the sulfate salt include a higher alcohol sulfate salt, an alkyl sulfate salt, and the like. Examples of the phosphate salt include an alkyl phosphate salt and the like.

Examples of the nonionic surfactant include an ether-type surfactant, an ether ester-type surfactant, an ester-type surfactant, an acetylene-type surfactant, and the like. Examples of the ether ester-type surfactant include a polyoxyethylene ether of an glycerol ester and the like. Examples of the ester-type surfactant include a polyethylene glycol fatty acid ester, glycerol ester, sorbitan ester, and the like. Examples of the acetylene-type surfactant include acetylene alcohol, acetylene glycol, an ethylene oxide adduct of acetylene diol, and the like.

Examples of the amphoteric surfactant include a betaine-type surfactant.

These surfactants may be used either individually or in combination.

Among these surfactants, the anionic surfactant is preferable, with the sulfonate being particularly preferable. As the sulfonate, the alkylbenzenesulfonate is preferable, with dodecylbenzenesulfonate being particularly preferable.

The surfactant is preferably added in an amount of 1 mass% or less, and more preferably 0.001 to 0.1 mass%, based on the mass of the chemical mechanical polishing aqueous dispersion during use. If the amount of the surfactant is within this range, a smooth polished surface can be obtained after the silicon nitride film has been polished and removed.

### 1.4.3 Acid or base

The chemical mechanical polishing aqueous dispersion according to this embodiment may include an acid or a base, if necessary. The pH of the chemical mechanical polishing aqueous dispersion according to this embodiment must be adjusted to 4 to 5, as described above. The acid or the base may be used to adjust the pH of the chemical mechanical polishing aqueous dispersion.

Examples of the acid include an organic acid and an inorganic acid other than those mentioned above.

Examples of the organic acid include paratoluenesulfonic acid, dodecylbenzenesulfonic acid, isoprenesulfonic acid, gluconic acid, glycolic acid, and the like.

Examples of the base include an organic base and an inorganic base.

Examples of the organic base include tetramethy hydroxide and the like.

Examples of the inorganic base include an alkali metal hydroxide. Specific examples of the alkali metal hydroxide include sodium hydroxide, potassium hydroxide, rubidium hydroxide, cesium hydroxide, and the like.

### 1.4.4 Water-soluble polymer

The chemical mechanical polishing aqueous dispersion according to this embodiment may include a water-soluble polymer, if necessary. The water-soluble polymer adheres to the surface of the polishing target surface to reduce the polishing friction. Dishing and erosion can be suppressed by adding the water-soluble polymer.

Examples of the water-soluble polymer include polyacrylamide, polyacrylic acid, polyvinyl alcohol, polyvinylpyrrolidone, hydroxyethylcellulose, and the like.

The water-soluble polymer may be added in such an amount that the chemical mechanical polishing aqueous dispersion has a viscosity of less than 2 mPa·s. Since the viscosity of the chemical mechanical polishing aqueous dispersion according to the invention is mainly determined by the weight average molecular weight and the content of the water-soluble polymer, the viscosity of the chemical mechanical polishing aqueous dispersion may be adjusted taking the balance between the weight average molecular weight and the content of the water-soluble polymer into consideration. If the viscosity of the chemical mechanical polishing aqueous dispersion is more than 2 mPa·s, the polishing rate may decrease. Moreover, it may be difficult to stably supply the chemical mechanical polishing aqueous dispersion to an abrasive cloth due to an increase in the viscosity of the chemical mechanical polishing aqueous dispersion. As result, an increase in the temperature of the abrasive cloth, polishing non-uniformity (deterioration in in-plane uniformity), and the like may occur, whereby the polishing rate or dishing may vary.

### 1.4.5 Anti-corrosion agent

Examples of an anti-corrosion agent which may be used in the chemical mechanical polishing aqueous dispersion according to this embodiment include benzotriazole and a benzotriazole derivative. The term "benzotriazole derivative" used herein refers to a compound obtained by replacing at least one hydrogen atom of benzotriazole by a carboxyl group, a methyl group, an amino group, a hydroxyl group, or the like. Examples of the benzotriazole derivative include 4-carboxybenzotriazole and its salt, 7-carboxybenzotriazole and its salt, benzotriazole butyl ester, 1-hydroxymethylbenzotriazole, 1-hydroxybenzotriazole, and the like.

The anti-corrosion agent is preferably added in an amount of 1 mass% or less, and more preferably 0.001 to 0.1 mass%, based on the mass of the chemical mechanical polishing aqueous dispersion during use.

### 1.5 Preparation of chemical mechanical polishing aqueous dispersion

The chemical mechanical polishing aqueous dispersion according to this embodiment may be prepared by dissolving or dispersing each component in a solvent such as water. The dissolution or dispersion method is not particularly limited. An arbitrary method may be used insofar as each component can be dissolved or dispersed uniformly. The order and the method of mixing each component is not particularly limited.

The chemical mechanical polishing aqueous dispersion according to this embodiment may be prepared as a concentrated solution, and may be diluted with a solvent such as water before use.

### 1.6 Polishing rate ratio

The chemical mechanical polishing aqueous dispersion according to this embodiment preferably has a polishing rate ratio of the polysilicon film to the silicon oxide film (polysilicon film/silicon oxide film) and a polishing rate ratio of the silicon nitride film to the silicon oxide film (silicon nitride film/silicon oxide film) of 0.9 to 1.1.

If the polishing rate ratio of the polysilicon film to the silicon oxide film is 0.9 to 1.1, the polysilicon film and the silicon oxide film that form the polishing target surface can be simultaneously polished at almost equal rates.

If the polishing rate ratio of the silicon nitride film to the silicon oxide film is 0.9 to 1.1, the silicon nitride film and the silicon oxide film that form the polishing target surface can be simultaneously polished at almost equal rates.

Therefore, if these polishing rate ratios are 0.9 to 1.1, the polysilicon film, the silicon nitride film, and the silicon oxide film that form the polishing target surface can be simultaneously polished at almost equal rates so that the polishing target surface can be planarized.

### 2. Chemical mechanical polishing method and method of producing semiconductor device

A chemical mechanical polishing method and a method of producing a semiconductor device according to this embodiment are described below.

### 2.1 Chemical mechanical polishing method

A method of polishing a semiconductor substrate using the chemical mechanical polishing aqueous dispersion according to the invention includes supplying the chemical mechanical polishing aqueous dispersion to a polishing pad provided on a polishing platen, and relatively moving the polishing target surface and the polishing pad in a state in which the polishing target surface comes in contact with the polishing pad to polish the polishing target surface. As a polishing device, a polishing device having a holder that holds a semiconductor substrate and a polishing platen provided with a polishing pad may be used. As the polishing pad, nonwoven fabric, polyurethane foam, a porous fluororesin, or the like may be used. The chemical mechanical polishing aqueous dispersion is successively supplied to the polishing pad during polishing by a pump or the like. The chemical mechanical polishing aqueous dispersion is preferably supplied so that the surface of the polishing pad is necessarily covered with the polishing (polishing agent). The polished semiconductor substrate is washed sufficiently with a stream. After removing waterdrops that adhere to the semiconductor substrate by using a spin dryer or the like, the semiconductor substrate is dried.

The polishing target may be a semiconductor substrate having a polishing target surface formed by at least two films selected from a polysilicon film, a silicon nitride film, and a silicon oxide film.

The chemical mechanical polishing aqueous dispersion according to this embodiment may be used for shallow trench isolation (STI), for example. In normal shallow trench isolation, a silicon oxide film is removed by CMP. After stopping the polishing operation on a silicon nitride film, the silicon nitride film is melted and etched by using hot phosphoric acid. On the other hand, since the silicon oxide and the silicon nitride film can be polished successively (i.e., CMP is not stopped) by utilizing the chemical mechanical polishing aqueous dispersion according to the invention, the production efficiency can be improved.

The chemical mechanical polishing aqueous dispersion according to the invention may be used for a semiconductor device having a polishing target surface formed by a polysilicon film, a silicon nitride film, and a silicon oxide film. Since each film can be polished at an almost equal polishing rate, the polishing target surface can be chemically and mechanically polished while maintaining flatness. Moreover, since it is unnecessary to select a slurry corresponding to each polishing target and only one washing operation is necessary, the production efficiency can be improved.

### 3. Examples

The invention is described below by way of examples. Note that the invention is not limited to the following examples.

### 3.1 Production of substrate used for polishing performance evaluation

A semiconductor (silicon) substrate having a diagonal dimension of 200 mm was provided. A silicon oxide film (thickness: 1000 nm) was formed on the substrate by a CVD method or a thermal oxidation method. The substrate thus obtained is referred to as "substrate a".

A silicon nitride film (thickness: 200 nm) was formed on the semiconductor substrate by a CVD method. The substrate thus obtained is referred to as "substrate b".

A silicon oxide film (thickness: 400 nm) was formed on the semiconductor substrate by a CVD method or a thermal oxidation method. A polysilicon film (thickness: 600 nm) was then formed by a CVD method. The substrate thus obtained is referred to as "substrate c".

### 3.2 Preparation of aqueous dispersion containing inorganic abrasive grains

### 3.2.1 Aqueous dispersion containing colloidal silica

In the examples according to the invention, PL-1 (average particle diameter: 37 nm), PL-2 (average particle diameter: 52 nm), PL-3 (average particle diameter: 89 nm), PL-20 (average particle diameter: 180 nm) (manufactured by Fuso Chemical Co., Ltd.), Snowtex O (average particle diameter: 15 nm), and Snowtex OS (average particle diameter: 9 nm) (manufactured by Nissan Chemical Industries Ltd.) were used as colloidal silica. The average particle diameters of the PL-1 series products were measured by using a dynamic light scattering particle size analyzer ("LB550" manufactured by Horiba Ltd.). The average particle diameters of Snowtex O and Snowtex OS are values provided by the manufacturer.

### 3.2 Preparation of chemical mechanical polishing aqueous dispersion

A polyethylene bottle (volume: 10,000 cm³) was charged with a predetermined amount of the aqueous dispersion prepared in "3.2.1 Preparation of aqueous dispersion containing colloidal silica". After the addition of compounds shown in Tables 1 or 2 in amounts shown in Tables 1 or 2, the mixture was stirred sufficiently. The mixture was then filtered through a filter with a pore size of 5 micrometers to obtain chemical mechanical polishing aqueous dispersions of Examples 1 or 8 and Comparative Examples 1 to 10.

### 3.3 Chemical mechanical polishing test

The substrate a, the substrate b, and the substrate c (polishing targets) were chemically and mechanically polished under the following polishing conditions 1 by using the chemical mechanical polishing aqueous dispersions of Examples 1 or 8 and Comparative Examples 1 to 10.

### <Polishing conditions 1>

Polishing device: "EPO-112" manufactured by Ebara Corporation
Polishing pad: "IC1000/K-Groove" manufactured by Rodel Nitta
Chemical mechanical polishing aqueous dispersion supply rate: 200 ml/min
Platen rotational speed: 50 rpm
Polishing head rotational speed: 55 rpm
Polishing head pressure: 4.2 psi

### 3.3.1 Calculation of polishing rate ratio

The thicknesses of the substrate a, the substrate b, and the substrate c (polishing targets) before polishing were measured by using an optical interference thickness meter ("NanoSpec 6100" manufactured by Nanometrics Japan Ltd.). The substrates were polished for 60 seconds under the above-mentioned conditions. The thickness of the polishing target after polishing was measured by using the optical interference thickness meter, and the difference between the thickness before polishing and the thickness after polishing (i.e., the thickness reduced by chemical mechanical polishing) was calculated. This operation was performed twice, and the average value of the thickness reduced by chemical mechanical polishing was calculated. The polishing rate was calculated from the average value of the thickness reduced by chemical mechanical polishing and the polishing time.

The polishing rate ratio was calculated by dividing the polishing rate of the polysilicon film or the silicon nitride film by the polishing rate of the silicon oxide film. The results are shown in Tables 1 and 2.

**TABLE 1**

| | | Example | | | | | | | |
|---|---|---|---|---|---|---|---|---|---|
| | | 1 | 2 | 3 | 4 | 5 | 6 | 7 | 8 |
| Colloidal silica (A) | Average particle diameter (nm) | 52 | 52 | 37 | 52 | 37 | 52 | 89 | 15 |
| | Amount (mass%) | 2 | 2.2 | 4 | 1 | 3 | 1.9 | 0.5 | 4 |
| Acid ammonium salt (B) | Ammonium phosphate | 0.9 | 1.3 | 1.62 | 0.59 | - | 0.9 | 0.31 | 2 |
| | Diammonium phosphate | - | - | 0.07 | 0.03 | 1.4 | - | - | - |
| | Ammonium hydrogen sulfate | - | - | - | - | 1 | - | - | - |
| Additive | Diammonium hydrogen citrate | - | - | - | - | - | 0.1 | - | - |
| | Tartaric acid | - | - | - | - | - | - | 0.1 | - |
| (A)/(B) ratio | | 2.2 | 1.7 | 2.4 | 1.6 | 1.3 | 2.1 | 1.6 | 2 |
| pH | | 4.7 | 4.6 | 4.9 | 4.7 | 4.8 | 4.8 | 5 | 4.7 |
| Polishing rate (nm/min) | Polysilicon film | 53.0 | 57.3 | 44.8 | 39.0 | 34.2 | 54.5 | 32.2 | 21.9 |
| | Silicon nitride film | 56.1 | 61.2 | 46.2 | 44.3 | 36.4 | 53.8 | 34.0 | 22.1 |
| | Silicon oxide film | 57.0 | 63.5 | 46.7 | 41.5 | 38.0 | 52.4 | 35.6 | 20.3 |
| Polishing rate ratio | Polysilicon film | 0.93 | 0.90 | 0.96 | 0.94 | 0.90 | 1.04 | 0.90 | 1.08 |
| | Silicon nitride film | 0.98 | 0.96 | 0.99 | 1.07 | 0.96 | 1.03 | 0.96 | 1.09 |
| | Silicon oxide film | 1.00 | 1.00 | 1.00 | 1.00 | 1.00 | 1.00 | 1.00 | 1.00 |

**TABLE 2**

| | | Comparative Example | | | | | | | | | |
|---|---|---|---|---|---|---|---|---|---|---|---|
| | | 1 | 2 | 3 | 4 | 5 | 6 | 7 | 8 | 9 | 10 |
| Colloidal silica (A) | Average particle diameter (nm) | 52 | 89 | 37 | 52 | 52 | 37 | 180 | 9 | 52 | 52 |
| | Amount (mass%) | 5 | 0.09 | 4 | 0.18 | 3 | 1.5 | 0.6 | 1 | 1.5 | 1.5 |
| Acid ammonium salt (B) | Ammonium phosphate | 2.5 | 0.09 | 4 | 0.09 | 0.75 | 3 | 0.6 | 1 | - | - |
| | Diammonium phosphate | - | - | - | - | - | - | - | - | 0.45 | 0.6 |
| | mmonium hydrogen sulfate | - | - | - | - | - | - | - | - | 0.45 | 0.4 |
| Additive | Triammonium citrate | - | - | - | - | - | - | - | - | - | - |
| | Potassium succinate | - | - | - | - | - | - | - | - | - | - |
| (A)/(B) ratio | | 2 | 1 | 1 | 2 | 4 | 0.5 | 1 | 1 | 1.7 | 1.5 |
| pH | | 4.6 | 4.7 | 4.6 | 4.7 | 4.7 | 4.7 | 4.6 | 4.6 | 3.5 | 5.6 |
| Polishing rate (nm/min) | Polysilicon film | 74.5 | 3.8 | 40.1 | 4.9 | 58.6 | 17.5 | 39.5 | 6.0 | 38.5 | 60.1 |
| | Silicon nitride film | 86.1 | 4.3 | 46.5 | 3.2 | 61.7 | 18.9 | 42.1 | 1.8 | 72.1 | 19.6 |
| | Silicon oxide film | 111.5 | 5.6 | 48.9 | 4.5 | 73.4 | 16.6 | 53.8 | 3.6 | 58.0 | 22.2 |
| Polishing rate ratio | Polysilicon film | 0.67 | 0.68 | 0.82 | 1.09 | 0.80 | 1.05 | 0.73 | 1.67 | 0.66 | 2.71 |
| | Silicon nitride film | 0.77 | 0.77 | 0.95 | 0.71 | 0.84 | 1.14 | 0.78 | 0.50 | 1.24 | 0.88 |
| | Silicon oxide film | 1.00 | 1.00 | 1.00 | 1.00 | 1.00 | 1.00 | 1.00 | 1.00 | 1.00 | 1.00 |

### 3.4 Examples 1 to 8 and Comparative Examples 1 to 10

In Examples 1 to 8 and Comparative Examples 1 to 10, the component or the concentration of the chemical mechanical polishing aqueous dispersion was changed as shown in Tables 1 and 2. Tables 1 and 2 also show the test results.

When using the chemical mechanical polishing aqueous dispersions of Examples 1 to 8, the polishing rate ratio of the polysilicon film to the silicon oxide film and the polishing rate ratio of the silicon nitride film to the silicon oxide film were 0.9 to 1.1. The polishing rate of each film was 20 nm/min or more. Specifically, the chemical mechanical polishing aqueous dispersions of Examples 1 to 8 showed a sufficient polishing performance. Therefore, when a semiconductor device having a polishing target surface formed by a polysilicon film, a silicon nitride film, and a silicon oxide film is chemically and mechanically polished by using the chemical mechanical polishing aqueous dispersions of Examples 1 to 8, the polysilicon film, the silicon nitride film, and the silicon oxide film can be simultaneously polished at almost equal polishing rates.

In Comparative Example 1, the amount of the colloidal silica was set at 5 mass%. As a result, the mechanical polishing effect increased, whereby the polishing rate of the silicon oxide film increased to a large extent.

In Comparative Example 2, the amount of the colloidal silica was set at 0.09 mass %. As a result, the polishing rate of each film decreased to an impractical level.

In Comparative Example 3, the amount of the acid ammonium salt was set at 4 mass %. As a result, the balance between the polishing rate ratios was lost.

In Comparative Example 4, the amount of the acid ammonium salt was set at 0.09 mass%. As a result, the polishing rate of each film decreased to an impractical level.

In Comparative Example 5, the mass ratio (A)/(B) was set at four. As a result, the mechanical polishing effect increased, whereby the polishing rate of the silicon oxide film increased to a large extent.

In Comparative Example 6, the mass ratio (A)/(B) was set at 0.5. As a result, the balance between the polishing rate ratios was lost.

In Comparative Example 7, colloidal silica having an average particle diameter of 180 nm was used. As a result, the mechanical polishing effect increased, whereby the polishing rate of the silicon oxide film increased to a large extent.

In Comparative Example 8, colloidal silica having an average particle diameter of 9 nm was used. As a result, the polishing rate of each film decreased to an impractical level.

In Comparative Example 9, the pH of the chemical mechanical polishing aqueous dispersion was set at 3.5. As a result, the polishing rates of the silicon nitride film and the silicon oxide film increased to a large extent with respect to the polishing rate of the polysilicon film.

In Comparative Example 10, the pH of the chemical mechanical polishing aqueous dispersion was set at 5.6. As a result, the polishing rates of the silicon nitride film and the silicon oxide film decreased to a large extent with respect to the polishing rate of the polysilicon film.

As described above, the objective of the invention could not be achieved when using the chemical mechanical polishing aqueous dispersions of Comparative Examples 1 to 10.

### 3.5 Experimental examples

### 3.5.1 First experimental example

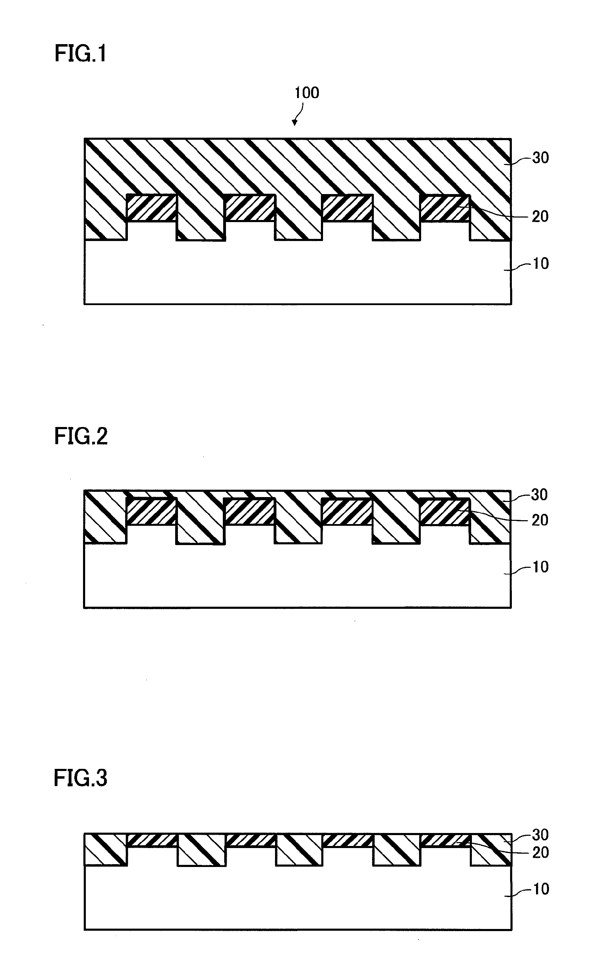

An evaluation substrate having a polishing target surface formed by a silicon nitride film 20 and a silicon oxide film 30 was provided by preliminarily polishing a commercially available test wafer 100 in which the silicon nitride film 20 was embedded. As the test wafer 100, Sematech 864 (manufactured by Sematech) was used. FIG. 1 is a cross-sectional view showing the test wafer 100. The thickness of the silicon oxide film 30 was 500 nm, and the thickness of the silicon nitride film 20 was 150 nm. The test wafer 100 was preliminarily polished under the following polishing conditions 2 by using CMS4301 and CMS4302 (manufactured by JSR Corporation). Preliminarily polishing was finished in a state in which 50 nm of the silicon oxide film 30 remained on the silicon nitride film 20 to obtain an evaluation substrate, as shown in FIG. 2.

After preliminarily polishing, the thickness of the silicon oxide film 30 on the silicon nitride film 20 within a 100-micrometer pattern pitch was measured by using an optical interference thickness meter "NanoSpec 6100", and found to be 60 nm. A step height of the silicon oxide film 30 was measured by using a contact-type profilometer "HRP240", but no step height was observed, and it was confirmed that the silicon oxide film 30 was almost smooth and flat as shown in FIG. 2.

### <Polishing conditions 2>

Polishing device: "EPO-112" manufactured by Ebara Corporation
Polishing pad: "IC1000/K-Groove" manufactured by Rodel Nitta
Chemical mechanical polishing aqueous dispersion supply rate: 200 ml/min
Platen rotational speed: 100 rpm
Polishing head rotational speed: 107 rpm
Polishing head pressure: 5.0 psi

The test wafer 100 was polished for 90 seconds by using the chemical mechanical polishing aqueous dispersion of Example 1 under the polishing conditions employed in Example 1. The thickness of the silicon oxide film 30 on the silicon nitride film 20 within the 100-micrometer pattern pitch after polishing was 0 nm. The amount of dishing of the silicon oxide film 30 within the 100-micrometer pattern pitch was 2 nm. It was confirmed that the silicon nitride film 20 and the silicon oxide film 30 were almost planarized, as shown in FIG 3.

### 3.5.2 Second experimental example

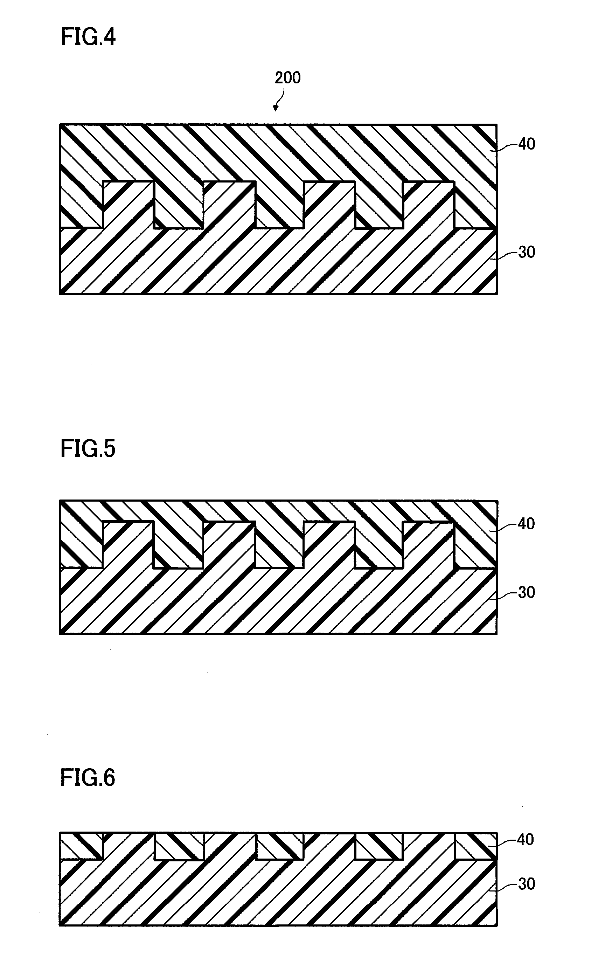

An evaluation substrate having a polishing target surface formed by a polysilicon film 40 and a silicon oxide film 30 was provided by preliminarily polishing a commercially available test wafer 200 in which the polysilicon film 40 was embedded. As the test wafer 200, SKW3PS (manufactured by SKW) was used. FIG 4 is a cross-sectional view showing the test wafer 200. The thickness of the polysilicon film 40 was 600 nm, and the thickness of the silicon oxide film 30 was 400 nm. The test wafer 200 was preliminarily polished under the following polishing conditions 3 by using a polysilicon polishing composition. Preliminarily polishing was finished in a state in which 50 nm of the polysilicon film 40 remained on the silicon oxide film 30 in depressions to obtain an evaluation substrate, as shown in FIG 5.

After preliminarily polishing, the thickness of the polysilicon film 40 on the silicon oxide film 30 within a 100-micrometer pattern pitch was measured by using an optical interference thickness meter "NanoSpec 6100", and found to be 50 nm. A step height of the polysilicon film 40 was measured by using a contact-type profilometer "HRP240", but no step height was observed, and it was confirmed that the polysilicon film 40 was almost smooth and flat as shown in FIG. 5.

### <Polishing conditions 3>

Polishing device: "EPO-112" manufactured by Ebara Corporation
Polishing pad: "IC1000/K-Groove" manufactured by Rodel Nitta
Chemical mechanical polishing aqueous dispersion supply rate: 200 ml/min
Platen rotational speed: 50 rpm
Polishing head rotational speed: 55 rpm
Polishing head pressure: 4.2 psi

The test wafer 200 was polished for 90 seconds by using the chemical mechanical polishing aqueous dispersion of Example 1 under the polishing conditions employed in Example 1. The thickness of the polysilicon film 40 on the silicon oxide film 30 within the 100-micrometer pattern pitch after polishing was 0 nm. The amount of dishing of the silicon oxide film 30 within the 100-micrometer pattern pitch was 4 nm. It was confirmed that the silicon oxide film 30 and the polysilicon film 40 were almost planarized, as shown in FIG. 6.

The results of the first experimental example and the second experimental example suggest that a polysilicon film, a silicon nitride film, and a silicon oxide film can be polished at almost equal rates when polishing a substrate having a polishing target surface formed by a polysilicon film, a silicon nitride film, and a silicon oxide film by using the chemical mechanical polishing aqueous dispersion according to the invention so that the polishing target surface is planarized without dishing.

## Claims

1. A chemical mechanical polishing aqueous dispersion comprising:
(A) 0.1 to 4 mass% of colloidal silica having an average particle diameter of 10 to 100 nm; and
(B) 0.1 to 3 mass% of at least one ammonium salt selected from ammonium phosphate, diammonium phosphate, and ammonium hydrogen sulfate,
the chemical mechanical polishing aqueous dispersion having a mass ratio (A)/(B) of the component (A) to the component (B) of 1 to 3 and a pH of 4 to 5 and being used to simultaneously polish at least two films that form a polishing target surface and are selected from a polysilicon film, a silicon nitride film, and a silicon oxide film.

2. The chemical mechanical polishing aqueous dispersion as defined in claim 1, further comprising:
at least one compound selected from nitric acid, sulfuric acid, carbonic acid, lactic acid, formic acid, benzoic acid, citric acid, tartaric acid, malic acid, malonic acid, fumaric acid, maleic acid, succinic acid, oxalic acid, phthalic acid, adipic acid, sebacic acid, and ammonium salts of nitric acid, sulfuric acid, carbonic acid, lactic acid, formic acid, benzoic acid, citric acid, tartaric acid, malic acid, malonic acid, fumaric acid, maleic acid, succinic acid, oxalic acid, phthalic acid, adipic acid, and sebacic acid.

3. The chemical mechanical polishing aqueous dispersion as defined in claim 1 or 2,
wherein a polishing rate ratio of the polysilicon film to the silicon oxide film (polysilicon film/silicon oxide film) and a polishing rate ratio of the silicon nitride film to the silicon oxide film (silicon nitride film/silicon oxide film) are in a range from 0.9 to 1.1.

4. A chemical mechanical polishing method for a semiconductor device, the method comprising:
simultaneously polishing at least two films that form a polishing target surface and are selected from a polysilicon film, a silicon nitride film, and a silicon oxide film by using the chemical mechanical polishing aqueous dispersion as defined in any one of claims 1 to 3.
